# DEMANDE DE BREVET EUROPEEN

(11) **EP 4 394 848 A1**
(43) Date de publication de la demande: **03.07.2024**
(21) Numéro de dépôt: 23215945.9
(22) Date de dépôt: 12.12.2023
(51) Int. Cl.: H01L 21/02, H01L 21/306, H01L 33/00, H01L 33/08

(54) **PROCÉDÉ DE RÉALISATION D'UN DISPOSITIF ÉLECTRONIQUE**

(30) Priorité: 19.12.2022 FR 2213826
(71) Demandeur: Commissariat à l'énergie atomique et aux énergies alternatives, 75015 Paris (FR)
(72) Inventeur: DUPRE, Ludovic, 38054 GRENOBLE CEDEX 09 (FR); PERNEL, Carole, 38054 GRENOBLE CEDEX 09 (FR)
(74) Mandataire: Thibon, Laurent

(57) **Abrégé**

La présente description concerne un procédé de réalisation d'un dispositif électronique comprenant les étapes successives suivantes :
a) former une structure comprenant un empilement de diode (101) disposé sur un premier substrat (103) et une couche sacrificielle (105) en un matériau semiconducteur interposée entre le premier substrat (103) et l'empilement de diode (101) ;
b) reporter la structure sur un deuxième substrat (131) ; et
c) retirer le premier substrat (103) par électropolissage de la couche sacrificielle (105) en appliquant une tension de polarisation à la couche sacrificielle (105) par l'intermédiaire de l'empilement de diode (101).

## Description

### Domaine technique

La présente description concerne de façon générale les dispositifs électroniques. La présente description vise plus particulièrement les procédés de réalisation de dispositifs électroniques comprenant une étape de retrait d'un substrat sur lequel a préalablement été formé un empilement de diode.

### Technique antérieure

Des procédés de réalisation de dispositifs comprenant une étape de retrait d'un substrat sur lequel a préalablement été formé un empilement de diode ont été proposés. Dans les procédés existants, des techniques de gravure humide, par exemple au moyen d'un mélange d'acide fluorhydrique et d'acide nitrique, de gravure sèche, par exemple en utilisant un plasma à base d'hexafluorure de soufre, ou de décollement au laser sont plus particulièrement mises en oeuvre pour parvenir au retrait du substrat.

Ces procédés de réalisation souffrent toutefois de divers inconvénients. En particulier, les procédés existants requièrent, une fois le substrat retiré, la mise en oeuvre d'étapes complexes d'élimination de couches tampon de sorte à exposer la ou les couches actives de l'empilement de diode.

### Résumé de l'invention

Un objet d'un mode de réalisation est de pallier tout ou partie des inconvénients des procédés connus de réalisation de dispositifs électroniques comprenant une étape de retrait d'un substrat sur lequel a préalablement été formé un empilement de diode.

Pour cela, un mode de réalisation prévoit un procédé de réalisation d'un dispositif électronique comprenant les étapes successives suivantes :
a) former une structure comprenant un empilement de diode disposé sur un premier substrat et une couche sacrificielle en un matériau semiconducteur interposée entre le premier substrat et l'empilement de diode ;
b) reporter la structure sur un deuxième substrat ; et
c) retirer le premier substrat par électropolissage de la couche sacrificielle en appliquant une tension de polarisation à la couche sacrificielle par l'intermédiaire de l'empilement de diode.

Selon un mode de réalisation, à l'étape b), le report est effectué par collage moléculaire conducteur du côté d'une première face de l'empilement de diode opposée au premier substrat.

Selon un mode de réalisation, à l'étape c), la structure est plongée dans un électrolyte.

Selon un mode de réalisation, à l'étape c), la tension de polarisation est appliquée entre une première électrode connectée à une couche conductrice disposée sur le deuxième substrat et une deuxième électrode plongée dans l'électrolyte.

Selon un mode de réalisation, la couche conductrice revêt le deuxième substrat.

Selon un mode de réalisation, une couche isolante dans laquelle sont formés des éléments de reprise de contact est interposée entre le deuxième substrat et la couche conductrice.

Selon un mode de réalisation, le procédé comprend en outre, postérieurement à l'étape c), une étape de gravure de l'empilement de diode de sorte à former une diode élémentaire à l'aplomb de chaque élément de reprise de contact.

Selon un mode de réalisation, à l'étape a), le premier substrat est une plaquette entière présentant une dimension latérale maximale strictement inférieure à celle du deuxième substrat.

Selon un mode de réalisation, le procédé comprend en outre, entre les étapes b) et c), une étape de formation de vias creux s'étendant depuis une face du premier substrat opposée à l'empilement de diode jusqu'à l'empilement de diode et traversant la couche sacrificielle.

Selon un mode de réalisation, l'empilement de diode comprend :
- une première couche dopée d'un premier type de conductivité revêtant la couche sacrificielle ;
- une couche active revêtant la première couche ; et
- une deuxième couche dopée d'un deuxième type de conductivité, opposé au premier type de conductivité, revêtant la couche active.

Selon un mode de réalisation, la couche sacrificielle est dopée du premier type de conductivité.

Selon un mode de réalisation, la première couche présente un niveau de dopage strictement inférieur, par exemple au moins dix fois inférieur, de préférence au moins mille fois inférieur, à celui de la couche sacrificielle.

Selon un mode de réalisation, la couche sacrificielle est en un matériau semiconducteur III-V.

Selon un mode de réalisation, la couche sacrificielle est en nitrure de gallium.

Selon un mode de réalisation, l'empilement de diode est un empilement de diode électroluminescente inorganique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figure 1A, figure 1B, figure 1C, figure 1D et figure 1E sont des vues en coupe, schématiques et partielles, illustrant des étapes successives d'un exemple d'un procédé de réalisation d'un dispositif électronique selon un mode de réalisation ;
la figure 2A et la figure 2B sont des vues en coupe, schématiques et partielles, illustrant des étapes successives d'une variante du procédé des figures 1A à 1E ;
les figure 3A, figure 3B, figure 3C, figure 3D et figure 3E sont des vues en coupe, schématiques et partielles, illustrant des étapes successives d'un exemple d'un procédé de réalisation d'un dispositif électronique selon un mode de réalisation ;
les figure 4A, figure 4B et figure 4C sont des vues en coupe, schématiques et partielles, illustrant des étapes successives d'un exemple d'un procédé de réalisation d'un dispositif électronique selon un mode de réalisation ;
la figure 5 est une vue en coupe, schématique et partielle, illustrant une étape d'une variante du procédé des figures 4A à 4C ; et
la figure 6 est un graphique représentant des variations de taille et de densité de pores à l'intérieur d'une couche en nitrure de gallium en fonction d'un niveau de dopage et d'une tension de polarisation appliqué à ladite couche.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diodes et de leurs circuits de commande n'a pas été détaillée, la réalisation de telles diodes et de tels circuits étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

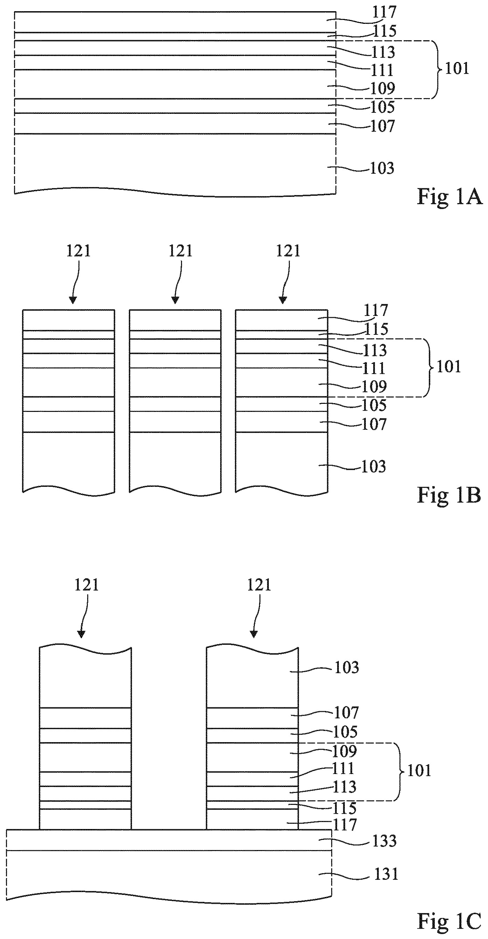

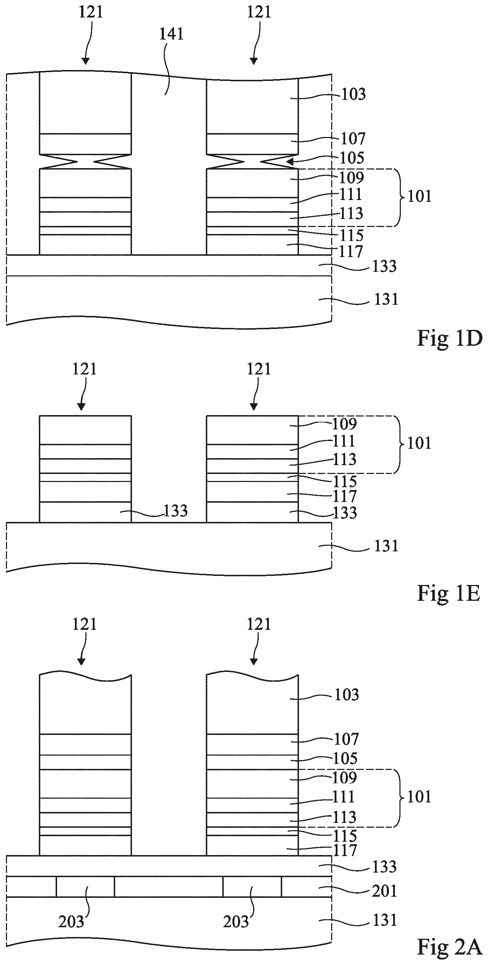

Les figure 1A, figure 1B, figure 1C, figure 1D et figure 1E sont des vues en coupe, schématiques et partielles, illustrant des étapes successives d'un exemple d'un procédé de réalisation d'un dispositif électronique selon un mode de réalisation.

La figure 1A illustre plus particulièrement une étape de formation d'une structure comprenant un empilement de diode 101, par exemple un empilement de diode électroluminescente (LED) inorganique, disposé sur un substrat 103, et une couche sacrificielle 105 en un matériau semiconducteur interposée entre le substrat 103 et l'empilement de diode 101.

Le substrat 103 est par exemple une plaquette ou un morceau de plaquette en un matériau semiconducteur, par exemple le silicium, en saphir, en nitrure de gallium ou en tout autre matériau sur lequel un empilement de diode peut être formé. À titre d'exemple, le substrat 103 est un substrat autoporteur (« free-standing », en anglais) en nitrure de gallium. Dans l'exemple du procédé exposé en relation avec les figures 1A à 1E, le substrat 103 est un substrat de support temporaire destiné à être retiré, ou éliminé, lors de la fabrication du dispositif.

Dans l'exemple représenté, le substrat 103 est revêtu, sur l'une de ses faces tournée vers l'empilement de diode 101 (la face supérieure du substrat 103, dans l'orientation de la figure 1A), d'une couche tampon 107. La couche tampon 107 est par exemple destinée à former une interface entre le substrat 103 et l'empilement de diode 101, par exemple afin d'améliorer la qualité cristalline des matériaux de l'empilement de diode 101. À titre d'exemple, la couche tampon 107 est formée par croissance épitaxiale depuis la face supérieure du substrat 103.

Dans l'exemple illustré, une face de la couche tampon 107 opposée au substrat 103 (la face supérieure de la couche tampon 107, dans l'orientation de la figure 1A) est revêtue de la couche sacrificielle 105. La couche sacrificielle 105 est par exemple en un matériau semiconducteur inorganique, par exemple un composé III-V comprenant au moins un premier élément du groupe III, un deuxième élément du groupe V et, éventuellement, un troisième élément, par exemple un élément du groupe III autre que le premier élément. À titre d'exemple, le matériau de la couche sacrificielle 105 est choisi parmi le nitrure de gallium (GaN), le nitrure d'indium (InN), le nitrure d'indium-gallium (InGaN), le nitrure d'aluminium (AlN), le nitrure d'aluminium-gallium (AlGaN) et le nitrure d'indium-gallium-aluminium (InGaAlN).

La couche tampon 107 est par exemple en le même matériau que la couche sacrificielle 105, par exemple en nitrure de gallium.

La couche sacrificielle 105 est par exemple fortement dopée d'un premier type de conductivité, par exemple le type N (dopage N⁺⁺), et présente par exemple un niveau de dopage compris entre 1 x 10¹⁹ et 1 x 10²⁰ at./cm³, par exemple dans le cas d'un dopage à base de silicium, le niveau de dopage pouvant atteindre environ 1 x 10²² at./cm³, par exemple dans le cas d'un dopage à base de germanium. À titre d'exemple, la couche sacrificielle 105 est formée par croissance épitaxiale depuis la face de la couche tampon 107 opposée au substrat 103 (la face supérieure de la couche tampon 107, dans l'orientation de la figure 1A).

Bien qu'une seule couche tampon 107 située entre le substrat 103 et la couche sacrificielle 105 ait été illustrée en figure 1A, la structure peut alternativement comprendre un empilement d'au moins deux couches tampon interposées entre le substrat 103 et la couche sacrificielle 105, les épaisseurs et les matériaux respectifs de ces couches tampon étant par exemple choisis en fonction du ou des matériaux présents dans l'empilement de diode 101.

L'empilement de diode 101 revêt une face de la couche sacrificielle 105 opposée au substrat 103 (la face supérieure de la couche sacrificielle 105, dans l'orientation de la figure 1A). Dans l'exemple représenté, l'empilement de diode 101 comprend une couche 109 dopée du premier type de conductivité (le type N, dans cet exemple) revêtant la face supérieure de la couche sacrificielle 105, une couche active 111 revêtant la face supérieure de la couche 109, et une couche 113 dopée d'un deuxième type de conductivité (le type P, dans cet exemple), opposé au premier type de conductivité, revêtant la face supérieure de la couche active 111. La couche 109 de l'empilement de diode 101 présente par exemple un niveau de dopage strictement inférieur, par exemple au moins dix fois inférieur, de préférence au moins mille fois inférieur, à celui de la couche sacrificielle 105. À titre d'exemple, la couche 109 présente un niveau de dopage de l'ordre de 1 x 10¹⁸ at./cm³. À titre d'exemple, les couches 109 et 113 sont en le même matériau que la couche sacrificielle 105, par exemple en nitrure de gallium.

Dans l'exemple illustré en figure 1A où l'empilement de diode 101 est un empilement de type LED, les couches 109 et 113 sont par exemple respectivement une couche d'injection et/ou de transport d'électrons et une couche d'injection et/ou de transport de trous. La couche active 111 est, dans cet exemple, une couche émissive destinée à émettre de la lumière vers un milieu extérieur lorsqu'une différence de potentiel est appliquée entre les couches 109 et 113 disposées de part et d'autre de la couche active 111. Bien que cela n'ait pas été détaillé en figure 1A, l'empilement de diode 101 peut en outre comprendre une ou plusieurs couches de blocage de trous, par exemple interposées entre la couche émissive 111 et la couche 109 d'injection et/ou de transport d'électrons, et/ou une ou plusieurs couches de blocage d'électrons, par exemple interposées entre la couche émissive 111 et la couche 113 d'injection et/ou de transport de trous.

À titre d'exemple, la couche active 111 comprend des puits quantiques multiples (« Multiple Quantum Wells » - MQW, en anglais).

Dans l'exemple illustré, une couche électriquement conductrice 115 revêt une face de l'empilement de diode 101 opposée au substrat 103 (la face supérieure de l'empilement de diode 101, dans l'orientation de la figure 1A). Dans cet exemple, la couche conductrice 115 revêt plus précisément la face supérieure de la couche 113. La couche conductrice 115 est par exemple une électrode d'anode connectée à l'empilement de diode 101 par la couche 113 d'injection et/ou de transport de trous. À titre d'exemple, la couche conductrice 115 est en un métal ou en un alliage métallique.

Dans l'exemple représenté, une autre couche électriquement conductrice 117 revêt une face de la couche conductrice 115 opposée au substrat 103 (la face supérieure de la couche conductrice 115, dans l'orientation de la figure 1A). À titre d'exemple, la couche conductrice 117 est en un métal, par exemple le titane, ou en un alliage métallique.

La figure 1B illustre plus particulièrement une étape ultérieure de découpe (« dicing », en anglais) de la structure précédemment décrite en relation avec la figure 1A.

Dans l'exemple représenté, la structure de la figure 1A est découpée sur toute sa hauteur de sorte à former des vignettes 121. Chaque vignette 121 comprend une partie du substrat 103 et un empilement vertical comportant dans l'ordre, depuis le substrat 103, des parties de la couche tampon 107, de la couche sacrificielle 105, de l'empilement de diode 101, de la couche conductrice 115 et de la couche conductrice 117.

À titre d'exemple, chaque vignette 121 présente, en vue de dessus, un pourtour de forme sensiblement rectangulaire, circulaire ou carrée, et une surface comprise entre quelques micromètres carrés et quelques centimètres carrés.

Bien que trois vignettes 121 aient été représentées en figure 1B, l'étape de découpe peut bien entendu conduire à la formation d'un nombre de vignettes 121 différent de trois, par exemple plusieurs dizaines ou plusieurs centaines de vignettes 121.

La figure 1C illustre plus particulièrement une structure obtenue à l'issue d'une étape ultérieure de report des vignettes 121 (de deux vignettes 121, dans l'exemple illustré) sur un substrat 131.

Les vignettes 121 sont par exemple d'abord retournées par rapport à l'orientation de la figure 1B puis mises en contact, par la face de la couche 117 opposée au substrat 103 (la face inférieure de la couche 117, dans l'orientation de la figure 1C) avec une couche électriquement conductrice 133 revêtant une face du substrat 131 (la face supérieure du substrat 131, dans l'orientation de la figure 1C). Au cours de cette étape, les vignettes 121 sont fixées au substrat 131. À titre d'exemple, la fixation des vignettes 121 sur le substrat 131 est obtenue par collage moléculaire entre les deux surfaces mises en contact. Dans le cas où les couches 117 et 133 sont en un métal ou en un alliage métallique conducteur, le collage est qualifié de « métal/métal » ou de « conducteur ».

Le substrat 131 est par exemple une plaquette ou un morceau de plaquette en un matériau semiconducteur, par exemple le silicium. Bien que cela n'ait pas été détaillé en figure 1C, une couche électriquement isolante, par exemple en dioxyde de silicium, peut être prévue entre le substrat 131 et la couche conductrice 133. À titre d'exemple, la couche conductrice 133 est en le même matériau que la couche 117, par exemple le titane.

La figure 1D illustre plus particulièrement une étape ultérieure d'élimination de la couche sacrificielle 105.

Dans l'exemple représenté, la couche sacrificielle 105 est éliminée par électropolissage en lui appliquant une tension de polarisation par l'intermédiaire de l'empilement de diode 101. La structure précédemment décrite en relation avec la figure 1C est par exemple plongée dans un électrolyte 141 et une tension de polarisation ou d'anodisation V_pol est par exemple appliquée, par un potensiostat, entre une première électrode, par exemple une électrode d'anode connectée à la couche conductrice 133, et une deuxième électrode, par exemple une électrode de cathode en platine plongée dans l'électrolyte 141. Afin de ne pas surcharger le dessin, le potentiostat et les première et deuxième électrodes d'application de la tension de polarisation V_pol n'ont pas été représentés en figure 1D. La tension V_pol est par exemple sensiblement égale à la somme d'une tension V_LED, provenant d'une chute de tension causée par l'empilement de diode 101, et d'une tension E appliquée à, ou vue par, la couche sacrificielle 105 (V_pol = E + V_LED) . À titre d'exemple, pour une densité de courant d'anodisation égale à environ 100 µA/cm², la chute de tension V_LED est égale à environ 2 V et la tension E à laquelle est soumise la couche 105 est égale à environ 18 V, la tension d'anodisation V_pol appliquée par le potentiostat étant alors égale à environ 20 V.

À titre d'exemple, l'électrolyte 141 est une solution aqueuse d'acide oxalique présentant une concentration molaire comprise entre 0,3 et 0,9 M.

Dans l'exemple représenté, l'électropolissage conduit à une porosification de la couche sacrificielle 105. Dans l'exemple illustré en figure 1D, le matériau de la partie de la couche sacrificielle 105 de chaque vignette 121 est progressivement éliminé depuis ses flancs vers une région centrale de la partie de la couche sacrificielle 105. À titre d'exemple, la vitesse d'électropolissage de la couche sacrificielle 105 est comprise entre 0,01 et 2 cm/h, par exemple entre 1 et 2 cm/h.

L'électropolissage est symbolisé, en figure 1D, par le fait que la couche sacrificielle 105 présente des flancs en V. Cet exemple n'est toutefois pas limitatif, les flancs de la couche sacrificielle 105 pouvant présenter, sous l'action de l'électropolissage, une forme quelconque, par exemple une forme sensiblement circulaire concave ou une forme plane, correspondant par exemple à la forme d'un front d'électropolissage se déplaçant latéralement vers le centre de la couche.

La figure 1E illustre plus particulièrement une structure obtenue à l'issue d'étapes ultérieures de retrait du substrat 103 et de gravure de la couche 133.

Les parties du substrat 103 et de la couche tampon 107 de chaque vignette 121 sont par exemple retirées, c'est-à-dire désolidarisées de l'empilement de diode 101, après élimination par électropolissage de la couche sacrificielle 105 au cours de l'étape décrite ci-dessus en relation avec la figure 1D. Dans l'exemple illustré en figure 1E, la couche sacrificielle 105 est totalement éliminée.

Un avantage lié au fait d'appliquer la tension V_pol entre une électrode connectée à la couche 133 et une autre électrode plongée dans l'électrolyte 141 comme exposé ci-dessus en relation avec la figure 1D est que cela permet un contrôle précis de la zone de détachement des parties du substrat 103 et de la couche tampon 107 de chaque vignette 121 par rapport à l'empilement de diode 101.

Dans l'exemple représenté, des parties de la couche 133 situées entre les vignettes 121 sont éliminées, par exemple par photolithographie puis gravure, tandis que d'autres parties de la couche 133 situées à l'aplomb des vignettes 121 sont conservées. Cela permet par exemple d'isoler électriquement chaque vignette 121 des autres vignettes 121.

Des étapes ultérieures du procédé de fabrication du dispositif électronique peuvent ensuite être mises en oeuvre à partir de la structure illustrée en figure 1E, le substrat 131 étant par exemple destiné à être conservé à l'issue de ces étapes.

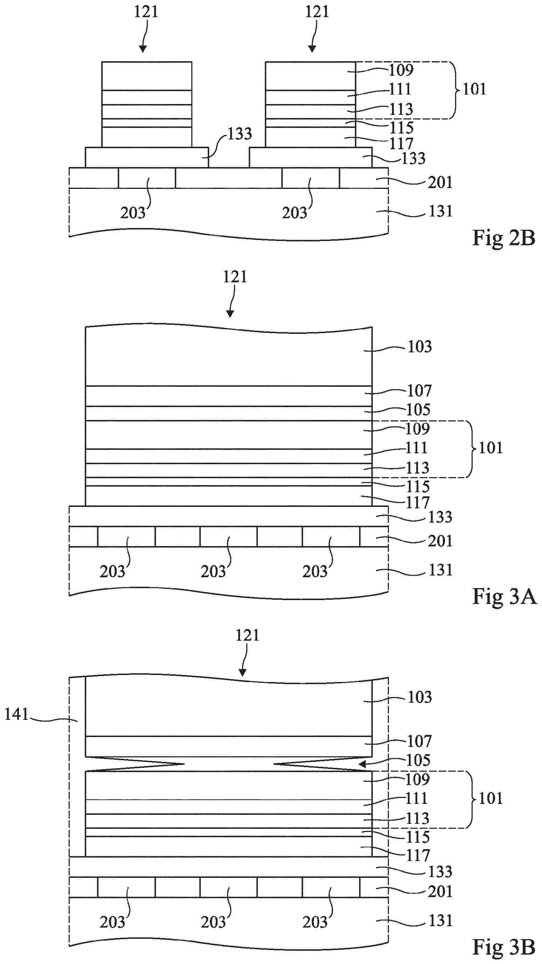

La figure 2A et la figure 2B sont des vues en coupe, schématiques et partielles, illustrant des étapes successives d'une variante du procédé des figures 1A à 1E.

La figure 2A illustre plus particulièrement une structure obtenue à l'issue d'une étape de report des vignettes 121 sur le substrat 131 analogue à l'étape précédemment décrite en relation avec la figure 1C.

L'étape illustrée en figure 2A diffère de l'étape illustrée en figure 1C en ce que, dans l'étape illustrée en figure 2A, une couche électriquement isolante 201, par exemple en dioxyde de silicium, est interposée entre le substrat 131 et la couche électriquement conductrice 133. Dans l'exemple représenté, des éléments de reprise de contact 203, par exemple des plots électriquement conducteurs, sont formés dans la couche isolante 201 et affleurent la face de la couche isolante 201 revêtue de la couche 133 (la face supérieure de la couche isolante 201, dans l'orientation de la figure 2A). À titre d'exemple, la couche isolante 201 et les éléments de reprise de contact 203 font partie d'un empilement d'interconnexion non détaillé en figure 2A. Les éléments de reprise de contact 203 sont par exemple destinés à connecter chaque vignette 121 à un circuit de commande (non représenté) formé dans et sur le substrat 131.

À titre d'exemple, le substrat 131 est dit « actif », c'est-à-dire que le substrat 131 comprend des composants électroniques actifs tels que des transistors. Le substrat 131 est par exemple de type CMOS (de l'anglais « Complementary Metal-Oxide-Semiconductor » - métal-oxyde-semiconducteur complémentaire) ou de type TFT (de l'anglais « Thin-Film Transistor » - transistor en couches minces).

La figure 2B illustre plus particulièrement une structure obtenue à l'issue d'étapes ultérieures de retrait du substrat 103 et de gravure de parties de la couche 133 situées entre les vignettes 121 analogues aux étapes précédemment décrites en relation avec la figure 1E.

La couche sacrificielle 105 est éliminée par électropolissage, par exemple dans des conditions similaires à celles exposées précédemment en relation avec la figure 1D, de sorte à retirer, ou éliminer, la couche tampon 107 et le substrat 103. À titre d'exemple, les parties de la couche 133 s'étendant latéralement entre les vignettes 121 sont ensuite éliminées par photolithographie puis gravure.

Dans l'exemple représenté, chaque vignette 121 est située à l'aplomb d'un élément de reprise de contact 203 différent des éléments de reprise de contact 203 à l'aplomb desquels sont situées les autres vignettes 121. Chaque élément de reprise de contact 203 permet par exemple de commander l'empilement de diode 101 de la vignette 121 sus-jacente indépendamment des empilements de diode 101 des autres vignettes 121 du dispositif électronique.

Des étapes ultérieures du procédé de fabrication du dispositif électronique peuvent ensuite être mises en oeuvre à partir de la structure illustrée en figure 2B, le substrat 131 étant par exemple destiné à être conservé à l'issue de ces étapes.

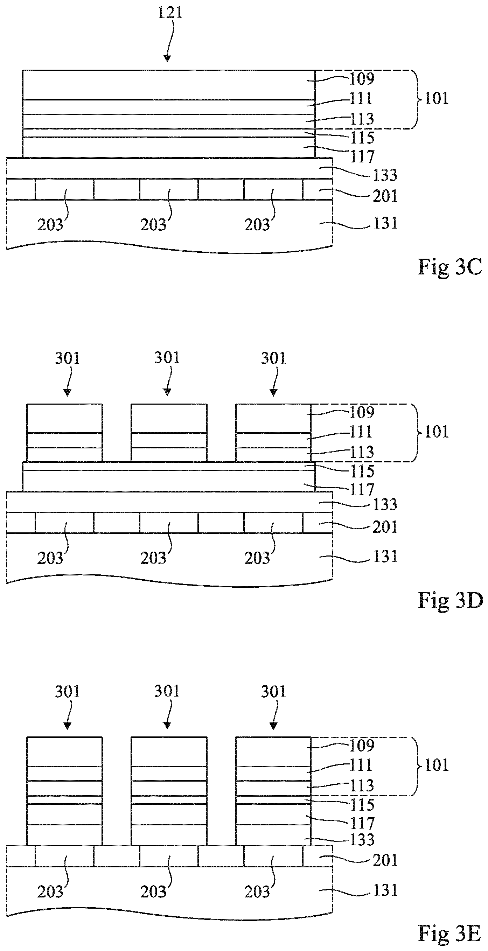

Les figure 3A, figure 3B, figure 3C, figure 3D et figure 3E sont des vues en coupe, schématiques et partielles, illustrant des étapes successives d'un exemple d'un procédé de réalisation d'un dispositif électronique selon un mode de réalisation.

La figure 3A illustre plus particulièrement une structure obtenue à l'issue d'une étape de report des vignettes 121 sur le substrat 131 analogue à l'étape précédemment décrite en relation avec la figure 2A. Bien que le report d'une seule vignette 121 ait été illustré en figure 3A, plusieurs vignettes 121 peuvent être reportées au cours de cette étape.

L'étape illustrée en figure 3A diffère de l'étape illustrée en figure 2A en ce que, dans l'étape illustrée en figure 3A, chaque vignette 121 est reportée à l'aplomb de plusieurs éléments de reprise de contact 203 (trois éléments de reprise de contact 203, dans l'exemple représenté).

La figure 3B illustre plus particulièrement une étape ultérieure d'électropolissage de la couche sacrificielle 105 analogue à l'étape précédemment décrite en relation avec la figure 1D.

La figure 3C illustre plus particulièrement une structure obtenue à l'issue d'une étape ultérieure d'élimination du substrat 103 et de la couche tampon 107.

La figure 3D illustre plus particulièrement une structure obtenue à l'issue d'une étape ultérieure de gravure de l'empilement de diode 101 de sorte à former des diodes élémentaires 301.

Dans l'exemple représenté, chaque diode élémentaire 301 est située à l'aplomb d'un élément de reprise de contact 203 distinct des éléments de reprise de contact 203 à l'aplomb desquels sont situées les autres diodes élémentaires 301. Dans cet exemple, les diodes élémentaires 301 présentent des dimensions latérales inférieures à celles des vignettes 121.

La figure 3E illustre plus particulièrement une structure obtenue à l'issue d'une étape ultérieure de gravure des couches conductrices 115, 117 et 133.

Dans l'exemple représenté, des parties des couches conductrices 115, 117 et 133 situées entre les diodes élémentaires 301 sont éliminées, par exemple par photolithographie puis gravure, tandis que d'autres parties des couches 115, 117 et 133 situées à l'aplomb des diodes élémentaires 301 sont conservées. Cela permet par exemple d'isoler électriquement chaque diode élémentaire 301 des autres diodes élémentaires 301.

Des étapes ultérieures du procédé de fabrication du dispositif électronique peuvent ensuite être mises en oeuvre à partir de la structure illustrée en figure 3E, le substrat 131 étant par exemple destiné à être conservé à l'issue de ces étapes.

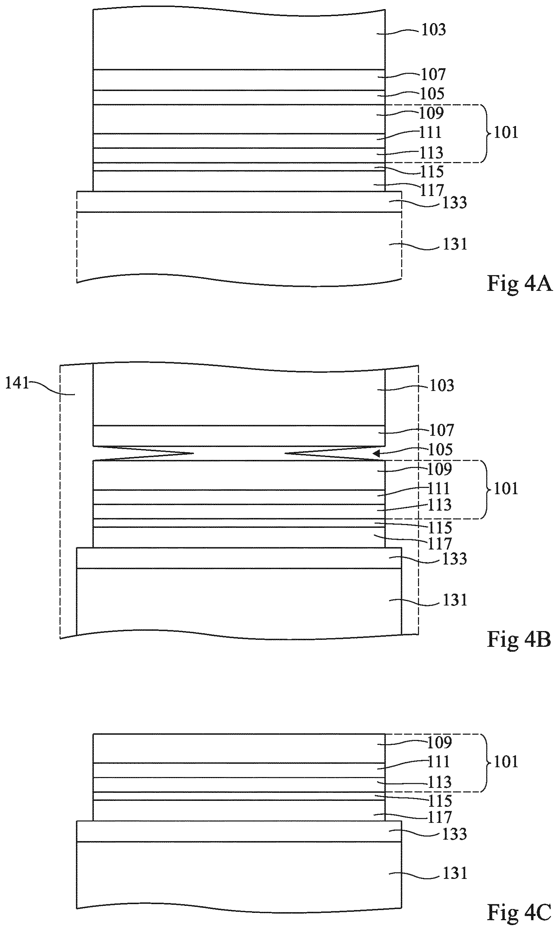

Les figure 4A, figure 4B et figure 4C sont des vues en coupe, schématiques et partielles, illustrant des étapes successives d'un exemple d'un procédé de réalisation d'un dispositif électronique selon un mode de réalisation.

La figure 4A illustre plus particulièrement une structure obtenue à l'issue d'une étape de report de la structure précédemment décrite en relation avec la figure 1A sur le substrat 131.

Dans l'exemple représenté, la structure de la figure 1A n'est pas découpée avant d'être reportée sur le substrat 131. Cela correspond par exemple à un cas dans lequel le substrat 103 est une plaquette entière sur laquelle est formé l'empilement de diode 101. Dans cet exemple, le substrat 103 présente une dimension latérale maximale strictement inférieure à celle du substrat 131. À titre d'exemple, dans le cas où les substrats 103 et 131 présentent, en vue de dessus, un pourtour de forme sensiblement circulaire, le substrat 103 présente un diamètre strictement inférieur à celui du substrat 131.

La figure 4B illustre plus particulièrement une étape ultérieure d'électropolissage de la couche sacrificielle 105 analogue à l'étape précédemment décrite en relation avec la figure 1D.

La figure 4C illustre plus particulièrement une structure obtenue à l'issue d'une étape ultérieure d'élimination du substrat 103 et de la couche tampon 107.

Des étapes ultérieures du procédé de fabrication du dispositif électronique peuvent ensuite être mises en oeuvre à partir de la structure illustrée en figure 4C, le substrat 131 étant par exemple destiné à être conservé à l'issue de ces étapes.

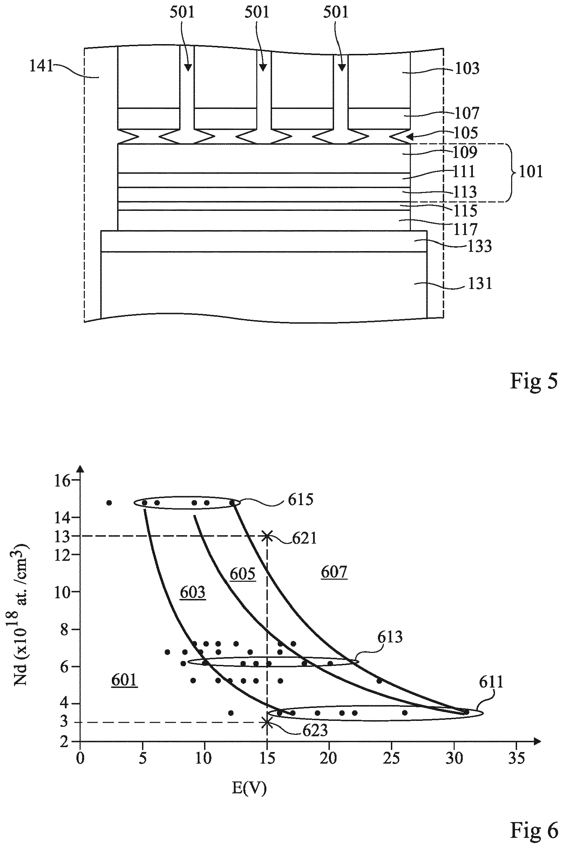

La figure 5 est une vue en coupe, schématique et partielle, illustrant une étape d'une variante du procédé des figures 4A à 4C.

La figure 5 illustre plus particulièrement une étape ultérieure d'électropolissage de la couche sacrificielle 105 analogue à l'étape précédemment décrite en relation avec la figure 4B.

L'étape illustrée en figure 5 diffère de l'étape illustrée en figure 4B en ce que, dans l'étape illustrée en figure 5, des trous ou vias creux 501 s'étendent depuis une face du substrat 103 opposée à l'empilement de diode 101 (la face supérieure du substrat 103, dans l'orientation de la figure 5) jusqu'à une face de l'empilement de diode 101 tournée vers le substrat 103 (la face supérieure de l'empilement de diode 101, dans l'orientation de la figure 5). Dans l'exemple représenté, les vias 501 traversent totalement le substrat 103, la couche tampon 107 et la couche sacrificielle 105 et débouchent sur une face de la couche 109 d'injection et/ou de transport d'électrons tournée vers le substrat 103 (la face supérieure de la couche 109, dans l'orientation de la figure 5).

Bien que seuls trois vias 501 aient été représentés en figure 5, un nombre de vias 501 supérieur à trois peut être prévu. Par ailleurs, les vias 501 peuvent, à titre de variante, être remplacés par des tranchées s'étendant, dans l'orientation de la figure 5, depuis la face supérieure du substrat 103 jusqu'à la face supérieure de la couche 109 d'injection et/ou de transport d'électrons.

Le fait de prévoir les vias 501 traversant la couche sacrificielle 105 permet avantageusement d'obtenir une surface de contact plus importante entre la couche sacrificielle 105 et l'électrolyte 141. Il en résulte une diminution de durée de l'étape d'électropolissage par rapport à l'étape précédemment décrite en relation avec la figure 4B.

La figure 6 est un graphique représentant des variations de taille et de densité de pores à l'intérieur d'une couche en nitrure de gallium, correspondant par exemple à la couche sacrificielle 105, en fonction d'un niveau de dopage Nd (exprimé en at./cm³, les valeurs indiquées en ordonnée étant à multiplier par 10¹⁸) et d'une tension de polarisation E (en volts, V) appliquée à ladite couche.

Dans l'exemple représenté, le graphique comprend :
- une région 601 de prérupture (« prebreakdown », en anglais) dans laquelle la structure cristalline de la couche commence à se dégrader ;
- une région 603 de porosification, dans laquelle des pores se forment à l'intérieur de la couche sans toutefois que ces pores ne diminuent sensiblement la cohésion mécanique de la couche ;
- une région 605 de limite d'électropolissage, dans laquelle un début de dégradation de la cohésion mécanique de la couche est observé ; et
- une région 607 d'électropolissage, dans laquelle la couche est éliminée sous l'effet de l'application de la tension de polarisation.

Par ailleurs, le graphique de la figure 6 comprend :
- une zone 611 correspondant à un niveau de dopage Nd égal à environ 3,5 x 10¹⁸ at./cm³, dans laquelle les pores présentent une taille comprise entre 25 et 52 nm et une densité comprise entre 0,12 x 10¹⁰ et 2,4 x 10¹⁰ cm⁻² ;
- une zone 613 correspondant à un niveau de dopage Nd égal à environ 6 x 10¹⁸ at./cm³, dans laquelle les pores présentent une taille comprise entre 24 et 39,7 nm et une densité comprise entre 3 x 10¹⁰ et 4,9 x 10¹⁰ cm⁻² ; et
- une zone 615 correspondant à un niveau de dopage Nd égal à environ 15 x 10¹⁸ at./cm³, dans laquelle les pores présentent une taille comprise entre 17 et 31 nm et une densité comprise entre 5,7 x 10¹⁰ et 10,6 x 10¹⁰ cm⁻².

La taille d'un pore correspond par exemple à la dimension latérale maximale du pore.

Dans le cas où la couche sacrificielle 105 est en nitrure de gallium, un niveau de dopage Nd de l'ordre de 13 x 10¹⁸ at./cm³ et une tension E appliquée à la couche 105 de l'ordre de 15 V, symbolisés par une croix 621 située dans la région 607 d'électropolissage, permettent par exemple de mettre en oeuvre les étapes d'électropolissage de la couche sacrificielle 105 précédemment décrites en relation avec les figures 1D, 3B, 4B et 5. Dans ce cas, la couche 109 de l'empilement de diode 101 présente par exemple un niveau de dopage de l'ordre de 3 x 10¹⁸ at./cm³, symbolisé par une croix 623 située dans la région 601 de prérupture. Cela permet d'éliminer la couche sacrificielle 105 sans endommager la couche 109 de l'empilement de diode 101. À titre d'exemple, la tension de polarisation V_pol est dans ce cas de l'ordre de 17 V. À titre de variante, le niveau de dopage de la couche 109 peut être tel que la croix 623 soit située dans la région 603 de porosification, voire dans la région 605 de limite d'électropolissage, par exemple inférieur ou égal à 10 x 10¹⁸ at./cm³.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable de combiner la variante des figures 2A et 2B avec le mode de réalisation des figures 4A à 4C et la variante de la figure 5, c'est-à-dire de prévoir, dans le mode de réalisation des figures 4A à 4C et dans la variante de la figure 5, un substrat 131 actif surmonté d'une couche isolante dans laquelle sont formés des éléments de reprise de contact.

Par ailleurs, la personne du métier est capable de combiner le mode de réalisation décrit ci-dessus en relation avec les figures 3A à 3E avec le mode de réalisation et la variante décrits en relation avec les figures 4A à 5. Pour cela, la personne du métier peut en particulier prévoir, à l'étape décrite en relation avec la figure 3A, le report sur le substrat 131 non pas d'une ou de plusieurs vignettes 121 mais de la structure décrite en relation avec la figure 1A.

La personne du métier est par ailleurs capable d'adapter la variante exposée en relation avec la figure 5 aux modes de réalisation et variantes décrites en relation avec les figures 1A à 3E, c'est-à-dire de prévoir des vias ou des tranchées permettant d'augmenter la surface de contact de la couche sacrificielle 105 avec l'électrolyte 141 lors de l'étape d'électropolissage de la couche sacrificielle 105.

Bien que les modes de réalisation décrits ci-dessus prennent pour exemple le cas où l'empilement de diode 101 est de type LED, ces modes de réalisation sont transposables par la personne du métier à des cas où l'empilement de diode 101 est de type quelconque, par exemple un empilement de diode de puissance, de diode photosensible, etc. Plus généralement, les modes de réalisation décrits s'appliquent à tout type d'empilement comprenant au moins une jonction P-N.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés ci-dessus.

Par ailleurs, la personne du métier est capable de choisir le matériau et le niveau de dopage Nd de la région sacrificielle 105 à partir des indications de la présente description. La personne du métier est en outre capable de choisir la tension de polarisation V_pol à appliquer lors de l'étape d'électropolissage de la couche sacrificielle 105, par exemple en fonction de la tension E que l'on souhaite appliquer à la couche 105.

## Revendications

1. Procédé de réalisation d'un dispositif électronique comprenant les étapes successives suivantes :
a) former une structure comprenant un empilement de diode (101) disposé sur un premier substrat (103) et une couche sacrificielle (105) en un matériau semiconducteur interposée entre le premier substrat (103) et l'empilement de diode (101) ;
b) reporter la structure sur un deuxième substrat (131) ; et
c) retirer le premier substrat (103) par électropolissage de la couche sacrificielle (105) en appliquant une tension de polarisation (E) à la couche sacrificielle (105) par l'intermédiaire de l'empilement de diode (101).

2. Procédé selon la revendication 1, dans lequel, à l'étape b), le report est effectué par collage moléculaire conducteur du côté d'une première face de l'empilement de diode (101) opposée au premier substrat (103).

3. Procédé selon la revendication 1 ou 2, dans lequel, à l'étape c), la structure est plongée dans un électrolyte (141) .

4. Procédé selon la revendication 3, dans lequel, à l'étape c), la tension de polarisation est appliquée entre une première électrode connectée à une couche conductrice (133) disposée sur le deuxième substrat (131) et une deuxième électrode plongée dans l'électrolyte (141).

5. Procédé selon la revendication 4, dans lequel la couche conductrice (133) revêt le deuxième substrat (131).

6. Procédé selon la revendication 4, dans lequel une couche isolante (201) dans laquelle sont formés des éléments de reprise de contact (203) est interposée entre le deuxième substrat (131) et la couche conductrice (133).

7. Procédé selon la revendication 6, comprenant en outre, postérieurement à l'étape c), une étape de gravure de l'empilement de diode (101) de sorte à former une diode élémentaire (301) à l'aplomb de chaque élément de reprise de contact (203).

8. Procédé selon l'une quelconque des revendications 1 à 7, dans lequel, à l'étape a), le premier substrat (103) est une plaquette entière présentant une dimension latérale maximale strictement inférieure à celle du deuxième substrat (131).

9. Procédé selon l'une quelconque des revendications 1 à 8, comprenant en outre, entre les étapes b) et c), une étape de formation de vias creux (501) s'étendant depuis une face du premier substrat (103) opposée à l'empilement de diode (101) jusqu'à l'empilement de diode (101) et traversant la couche sacrificielle (105).

10. Procédé selon l'une quelconque des revendications 1 à 9, dans lequel l'empilement de diode (101) comprend :
- une première couche (109) dopée d'un premier type de conductivité revêtant la couche sacrificielle (105) ;
- une couche active (111) revêtant la première couche ; et
- une deuxième couche (113) dopée d'un deuxième type de conductivité, opposé au premier type de conductivité, revêtant la couche active (111).

11. Procédé selon la revendication 10, dans lequel la couche sacrificielle (105) est dopée du premier type de conductivité.

12. Procédé selon la revendication 11, dans lequel la première couche (109) présente un niveau de dopage strictement inférieur, par exemple au moins dix fois inférieur, de préférence au moins mille fois inférieur, à celui de la couche sacrificielle (105).

13. Procédé selon l'une quelconque des revendications 1 à 12, dans lequel la couche sacrificielle (105) est en un matériau semiconducteur III-V.

14. Procédé selon l'une quelconque des revendications 1 à 13, dans lequel la couche sacrificielle (105) est en nitrure de gallium.

15. Procédé selon l'une quelconque des revendications 1 à 14, dans lequel l'empilement de diode (101) est un empilement de diode électroluminescente inorganique.
